# EUROPÄISCHE PATENTSCHRIFT

(11) **EP 0 523 311 B1**
(45) Veröffentlichungstag und Bekanntmachung des Hinweises auf die Patenterteilung: **28.06.1995**
(21) Anmeldenummer: 92100971.8
(22) Anmeldetag: 22.01.1992
(51) Int. Cl.: C23C 14/24, C23C 14/26

(54) **Reihenverdampfer für Vakuumbedampfungsanlagen**
Line evaporator for vacuum coating plants
Evaporateur en ligne pour les dispositifs de revêtement sous vide

(30) Priorität: 15.07.1991 DE 4123342
(43) Veröffentlichungstag der Anmeldung: 20.01.1993
(73) Patentinhaber: LEYBOLD AKTIENGESELLSCHAFT, D-63450 Hanau (DE)
(72) Erfinder: Schönherr, Bernhard, Dipl.-Ing., W-6050 Offenbach (DE)

(56) Entgegenhaltungen:
- EP-A- 0 456 892
- DE-A- 2 402 111
- DE-B- 1 237 401
- FR-A- 2 351 496
- US-A- 3 387 116

## Beschreibung

Die Erfindung betrifft einen Reihenverdampfer für Vakuumbedampfungsanlagen, insbesondere für Bandbedampfungsanlagen, bestehend aus mehreren, in der Prozeßkammer angeordneten, einzeln in der Leistung steuerbaren, durch Stromdurchgang beheizten, an backenförmig ausgebildeten elektrischen Zuleitungen anliegenden Verdampferschiffchen, wobei die Zuleitungen von einem sich über die gesamte Länge des Reihenverdampfers erstreckenden, elektrisch leitfähigen Tragkörper gehalten sind und die backenförmigen Zuleitungen der einen Polarität elektrisch leitend mit dem Tragkörper verbunden sind, während die backenförmigen Zuleitungen der anderen Polarität isoliert am Tragkörper gelagert und mit isoliert angeordneten elektrischen Zuleitungen in Verbindung stehen.

Bekannt ist ein Reihenverdampfer (US 3,387,116, US 2,969,448), bei dem das trogförmige Verdampferschiffchen zwischen einer ersten ortsfesten, stützenförmigen Zuleitung und einem unter Federspannung stehenden, an einer zweiten ortsfesten Zuleitung gehaltenen und geführten Druckstück eingespannt ist.

Weiterhin ist ein Reihenverdampfer für Bandbedampfungsanlagen bekannt (P 40 16 225.7), bestehend aus mehreren, einzelnen in der Leistung steuerbaren, durch Stromdurchgang beheizten, an stützenförmig ausgebildeten elektrischen Zuleitungen anliegenden Verdampfern, wobei die stützenförmigen Zuleitungen jeweils von einem sich über die gesamte Länge des Reihenverdampfers erstreckenden, elektrisch leitfähigen Tragkörper gehalten sind und die Zuleitungen der einen Polarität elektrisch leitend mit dem Tragkörper verbunden sind, während die Zuleitungen der anderen Polarität isoliert durch den Tragkörper hindurchgeführt und mit isoliert angeordneten Leitungsdrähten verbunden sind. Eine der elektrischen Zuleitungen eines Verdampfers ist dabei jeweils von einem Federelement beaufschlagt, dessen Vorspannung wiederum über einen Verstellnocken einstellbar ist, so daß die den Verdampfer in seiner Lage haltenden und sichernden Einspannkräfte einzeln justierbar sind.

Bei einem älteren Reihenverdampfer für Vakuumbedampfungsanlagen (EP 0 456 892 A1), bestehend aus mehreren, einzeln in der Leistung steuerbaren, durch Stromdurchgang beheizte, auf stützenförmig ausgebildeten elektrischen Zuleitungen befestigten Verdampfern, wobei die stützenförmigen Zuleitungen von einem sich über die gesamte Länge des Reihenverdampfers erstreckenden, elektrisch leitfähigen Tragkörper gehalten sind und die Zuleitungen der einen Polarität elektrisch leitend mit dem Tragkörper verbunden sind, während die Zuleitungen der anderen Polarität isoliert durch den Tragkörper hindurchgeführt und mit isoliert angeordneten Leitungsdrähten verbunden sind, sind die durch den Tragkörper mit Spiel hindurchgeführten stützenförmigen Zuleitungen von Federelementen beaufschlagt, die etwa parallel der Längserstreckungen der Verdampfer wirken und die Kopfteile der Zuleitungen an die diesen zugekehrten Stirnflächen der Verdampfer anpressen, wobei die Federelemente selbst gegenüber dem Tragkörper elektrisch isoliert gehalten und geführt oder aus isolierendem Werkstoff gebildet sind und die mit diesen Zuleitungen verbundenen Leitungsdrähte von einem Kühlmittel durchflossene Leiter sind oder als Kühlschläuche oder Kühlrohre ausgebildet sind, die zu den Leitungsdrähten parallel verlegt sind und in Kammern oder Kanälen einmünden, die in den Zuleitungen vorgesehen sind.

Ein Problem dieses älteren Reihenverdampfers besteht in der Anordnung der Kühleinrichtung in der Prozeßkammer selbst mit dem Nachteil, daß eine Leckage im Kühlkreislauf nicht nur das Abschalten der Anlage erfordert, sondern auch einen sehr aufwendigen Trocknungs- und Reinigungsprozeß zur Folge hat.

Der vorliegenden Erfindung liegt die Aufgabe zugrunde, einen Reihenverdampfer zu schaffen, bei dem eine Vielzahl von einzelnen Verdampfern zwischen den elektrischen Zuleitungen einspannbar sind, wobei zum einen sichergestellt sein soll, daß der Stromdurchgang während des Verdampfungsprozesses keinesfalls unterbrochen wird und zum anderen der bauliche Aufwand klein gehalten werden kann. Darüberhinaus soll sichergestellt sein, daß ein Defekt bzw. eine Leckage in der Kühlvorrichtung der Reihenverdampferanordnung nicht zu einem Wassereinbruch in die Prozeßkammer führen kann.

Diese Aufgabe wird erfindungsgemäß dadurch gelöst, daß jede backenförmige Zuleitung der anderen Polarität jeweils mit einem sich in einer parallelen Ebene zur Ebene der Verdampferschiffchen erstreckenden Verdrängerkörper kraftschlüssig verbunden oder einstückig mit dieser ausgebildet ist, wobei das dem Verdampfer abgekehrte Ende des Verdrängerkörpers dichtend durch die Wand der Prozeßkammer hindurchgeführt ist und so dem Umgebungsdruck ausgesetzt ist, wobei jeder Verdrängerkörper eine sich in seiner Längsrichtung erstreckende Sacklochbohrung aufweist, die jeweils mit einer Kühlwasserzuleitung und einer Kühlwasserrückführung korrespondiert, die beide von der Außenseite der Prozeßkammer her in das freie, der Umgebungsluft ausgesetzte Ende des Verdrängungskörpers einmünden.

Bevorzugte Ausführungsformen sind in den abhängigen Ansprüchen 2 bis 4 offenbart.

Die Erfindung läßt die verschiedensten Ausführungsmöglichkeiten zu; eine davon ist in den anhängenden Zeichnungen näher dargestellt, und zwar zeigen:

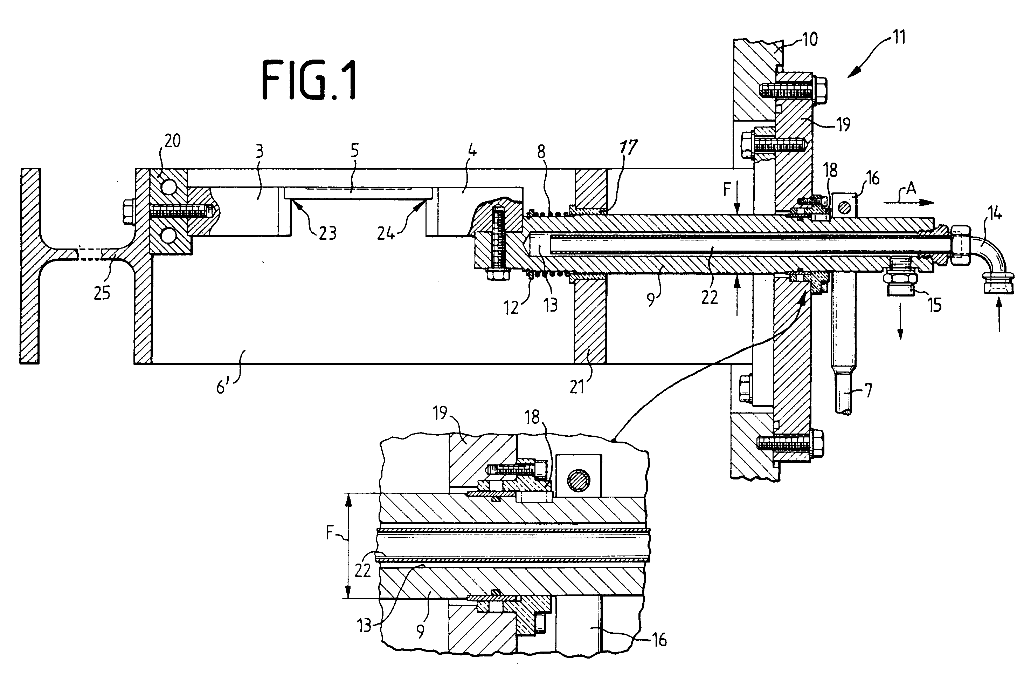

- Figur 1: eine Vorrichtung zur Halterung eines Verdampferschiffchens einer Vakuumbedampfungsanlage in der Seitenansicht und teilweise im Schnitt, und

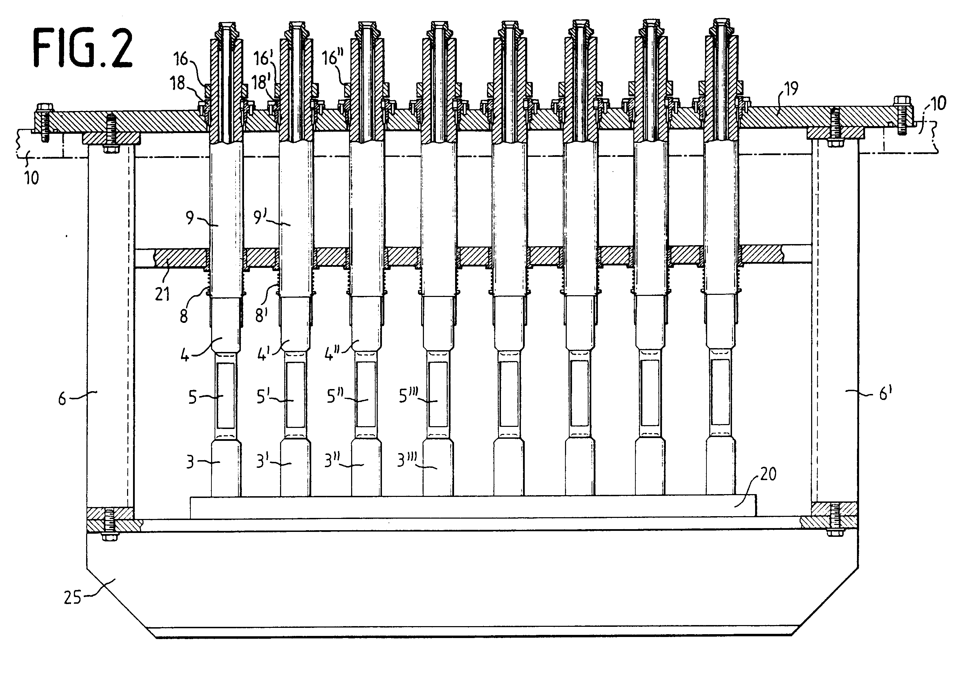

- Figur 2: die Draufsicht auf eine Vielzahl nebeneinander angeordneter Verdampfer einer Vakuumbedampfungsanlage (Verdampferbank), teilweise im Schnitt und in einem gegenüber der Darstellung nach Figur 1 verkleinertem Maßstab.

Der Reihenverdampfer besteht im wesentlichen aus dem an der Innenseite der Wand 10 der Prozeßkammer 11 über einen Zwischenflansch 19 fest angeordneten Tragkörper 6, der mit dem Tragkörper 6 fest verschraubten Masseschiene 20, den an der Masseschiene 20 abgestützten ersten Einspannbacken 3, 3', ... dem diesen ersten Einspannbacken 3, 3', ... gegenüberliegenden, jeweils von einem Verdrängerkörper 9 gehaltenen zweiten Einspannbacken 4, 4', ... dem von beiden Backen 3, 4 bzw. 3', 4' bzw. ... gehaltenen Verdampferschiffchen 5, 5', ..., der jeden Verdrängerkörper 9 umschließenden Stromklemme 16, 16', ... mit der jeweils an ihr befestigten Hoch-Stromzuführung 7, dem mit dem Tragkörper 6 einstückig ausgebildeten Querprofil bzw. der Stützrippe 21, den von der Stützrippe 21 jeweils umschlossenen elektrisch isolierenden Gleitlagerbuchsen 17, 17', ... der jeweils in eine Öffnung des Zwischenflansches 19 eingesetzten Schiebedurchführung 18, 18', ... für einen stabförmigen Verdrängerkörper 9, 9', ... der in jedem Verdrängerkörper 9 vorgesehenen Sacklochbohrung 13 mit eingesetztem Kühlmittelverteilungsrohr 22, den Stutzen 15, 15', ... für die Kühlwasser-Rückführungen und den Stutzen 14, 14', ... für die Kühlwasser-Zuleitungen.

Um das Verdampferschiffchen 5 in die Vorrichtung einsetzen zu können, muß zunächst der Verdrängerkörper 9 in Pfeilrichtung A entgegen der Kraft der Feder 8 nach rechts verschoben werden, was leicht zu bewerkstelligen ist, da der Verdrängerkörper im wesentlichen die Konfiguration eines zylindrischen Bolzens aufweist, der gegen nur geringe Reibung in der Gleitlagerbuchse 17 und der vakuumdichten Schiebedurchführung 18 bewegt werden muß. Das Verdampferschiffchen 5 läßt sich dann in die beiden Aussparungen 23, 24, die an den einander zugekehrten Stirnseiten der Backen 3, 4 vorgesehen sind, einsetzen. Wird nun der Verdrängerkörper 9 wieder freigegeben, dann drückt das Federelement 8, das sich einerseits an der einen Stirnseite der elektrisch isolierenden Gleitlagerbuchse 17 bzw. am Querprofil 21 abstützt und das andererseits am Kragen 12 des Verdrängerkörpers 9 anliegt, den Verdrängerkörper 9 soweit entgegen der Pfeilrichtung A nach links, daß das Verdampferschiffchen 5 mit ausreichender Zuspannung von den beiden Backen 3, 4 gehalten wird. Wenn sich nun beim Evakuieren der Prozeßkammer 11 eine Druckdifferenz zwischen dem Raum links von der Rezipienten-Wand 10 und der die Anlage umgebenden Atmosphäre einstellt, dann beaufschlagt der Differenzdruck die Querschnittsfläche F des Verdrängerkörpers 9, so daß sich die Zuspannung am Verdampferschiffchen 5 erheblich erhöht (z.B. um den Faktor 10) und ein absolut sicherer elektrischer Kontakt zwischen den Backen 3, 4 einerseits und dem Verdampferschiffchen 5 andererseits gegeben ist.

Von großer Bedeutung für die Betriebssicherheit der vorstehend beschriebenen Vorrichtung ist die Anordnung einer Kühleinrichtung in jedem einzelnen Verdrängerkörper 9. Das Kühlwasser fließt jeweils über die Zuleitung 14 und das Verteilungsrohr 22 in die Sacklochbohrung 13 und von dieser aus über den Stutzen 15 in den Kühlwasser-Rücklauf. Sollte sich während des Betriebes eine Leckage einstellen, kann diese nur im Bereich der beiden Stutzen 14, 15 auftreten; eine für die Betriebssicherheit der Gesamtanlage unbedeutende Situation, da keinesfalls Kühlmittel in das Innere der Prozeßkammer eintreten kann. Auch die elektrische Zuleitung 7 ist so ausgebildet, daß sie von außen her erfolgt, d.h. daß die Klemme 16, die mit dem Stromkabel 7 verbunden ist, jederzeit ausgetauscht werden kann, ohne daß es eines Eingriffs in das Innere der Prozeßkammer bedarf.

### Auflistung der Einzelteile

- 3: Einspannbacken, Zuleitung
- 4: Einspannbacken, Zuleitung
- 5, 5', ...: Verdampfer, Verdampferschiffchen
- 6: Tragkörper, Hauptrahmen
- 7: Leitungsdraht, Hochstromzuführung
- 8: Federelement
- 9: Verdrängerkörper, Bolzen
- 10: Wand, Gehäusewand
- 11: Prozeßkammer, Rezipient
- 12: Kragen
- 13: Sacklochbohrung, Ausnehmung
- 14: Kühlwasserzuleitung, Stutzen
- 15: Kühlwasserrückführung, Stutzen
- 16: Klemme, Stromklemme
- 17: isolierende Gleitlagerbuchse
- 18: isolierende Schiebedurchführung
- 19: Zwischenflansch
- 20: Masseschiene
- 21: Querprofil, Stützrippe
- 22: Kühlmittel-Verteilungsrohr
- 23: Aussparung
- 24: Aussparung
- 25: Stützkörper
- 26: Prozeßkammer

## Patentansprüche

1. Reihenverdampfer für Vakuumbedampfungsanlagen, insbesondere für Bandbedampfungsanlagen, bestehend aus mehreren, in der Prozeßkammer (11) angeordneten, einzeln in der Leistung steuerbaren, durch Stromdurchgang beheizten, an backenförmig ausgebildeten elektrischen Zuleitungen (3, 3', ..., 4, 4', ...) anliegenden Verdampferschiffchen (5, 5', ...), wobei die Zuleitungen (3, 4) von einem sich über die gesamte Länge des Reihenverdampfers erstreckenden, elektrisch leitfähigen Tragkörper (6, 25) gehalten oder geführt sind und die backenförmigen Zuleitungen (3, 3', ...) der einen Polarität elektrisch leitend und fest mit dem Tragkörper (6) verbunden sind, während die backenförmigen Zuleitungen (4) der anderen Polarität isoliert am Tragkörper (6, 25) gelagert und mit isoliert angeordneten elektrischen Stromzuführungen (7) verbunden sind, **dadurch gekennzeichnet**, daß jede backenförmige Zuleitung (4, 4', ...) der anderen Polarität jeweils mit einem sich in einer parallelen Ebene zur Ebene der Verdampferschiffchen (5, 5', ...) erstreckenden Verdrängerkörper (9, 9', ...) kraftschlüssig verbunden oder einstückig mit diesem ausgebildet ist, wobei jeweils das dem Verdampferschiffchen abgekehrte Ende des Verdrängerkörpers dichtend und längsverschiebbar durch die Wand (10) der Prozeßkammer (11) hindurchgeführt ist und dem Druck der Umgebungsluft ausgesetzt ist, wobei jeder Verdrängerkörper eine sich in seiner Längsrichtung erstreckende Sacklochbohrung (13) aufweist, die jeweils mit einer Kühlwasserzuleitung (14) und einer Kühlwasserrückführung (15) korrespondiert, die beide von der Außenseite der Prozeßkammer her in das freie, der Umgebungsluft ausgesetzte Ende des Verdrängungskörpers einmünden.

2. Reihenverdampfer nach Anspruch 1, **gekennzeichnet durch** eine sich einerseits am Tragkörper (6) oder der Innenseite der Wand (10) der Prozeßkammer (11) und andererseits an einem Kragen (12) oder einer Nase des Verdrängerkörpers (9) abstützendes Federelement (8) zur Erzeugung einer auf der mit dem Verdrängerkörper (9) verbundenen Backe (4) einwirkenden Vorspannkraft.

3. Reihenverdampfer nach einem oder mehreren der vorhergehenden Ansprüche, **dadurch gekennzeichnet**, daß das nach außen zu bis in die Umgebungsluft hervorstehende Ende des im wesentlichen stabförmigen Verdrängerkörpers (9) von einer Klemme (16) umgriffen ist, die mit der Stromzuführung (7) in Verbindung steht.

4. Reihenverdampfer nach einem oder mehreren der vorhergehenden Ansprüche, **dadurch gekennzeichnet**, daß der Verdrängerkörper (9) im Bereich der Schiebedurchführung (18) im Wandteil (10) der Prozeßkammer (11) und im Bereich der Gleitlagerbuchse (17) des Tragerkörpers (6) Abschnitte von jeweils gleichbleibender Querschnittsprofilierung aufweist.

## Claims

1. Line evaporator for vacuum coating plants, in particular for strip coating plants, consisting of a plurality of vaporising boats (5, 5', ...) disposed in the processing chamber (11) with individually controllable power, heated by the passage of a current and abutting jaw-like electrical supply lines (3, 3', ..., 4, 4', ...), the supply lines (3, 4) being held or guided by an electrically conductive support body (6, 25) extending over the entire length of the line evaporator and the jaw-like supply lines (3, 3', ...) of the one polarity being rigidly connected to the support body (6) in a current-conducting manner, whilst the jaw-like supply lines (4) of the other polarity are mounted in an insulated manner on the support body (6, 25) and are connected to insulated electrical leads (7),
characterised in that each jaw-like supply line (4, 4', ...) of the other polarity is connected non-positively to a displacement body (9, 9', ...) extending in a plane parallel to the plane of the evaporating boats (5, 5', ...) or is formed integrally therewith, in which case the respective end of the displacement body remote from the evaporating boat passes longitudinally displaceably through the wall (10) of the processing chamber (11) so as to form a seal and is exposed to the pressure of the ambient air, and each displacement body has a blind bore (13) extending in its longitudinal direction and respectively corresponding to a cooling water supply line (14) and a cooling water discharge line (15), both of which open from the exterior of the processing chamber into the free end of the displacement body exposed to the ambient air.

2. Line evaporator according to claim 1, characterised by a resilient element (8) bearing at one end on the support body (6) or on the inner face of the wall (10) of the processing chamber (11) and at the other end on a collar (12) or lug of the displacement body (9) in order to generate a prestressing force acting on the jaw (4) connected to the displacement body (9).

3. Line evaporator according to one of the aforesaid claims, characterised in that the end projecting on the outside into the ambient air of the substantially rod-like displacement body (9) is gripped by a clamp (16) communicating with the current lead (7).

4. Line evaporator according to one or more of the aforesaid claims, characterised in that the displacement body (9) has in the region of the linear motion leadthrough (18) in the wall portion (10) of the processing chamber (11) and in the region of the sliding bearing bush (17) of the support body (6) lengths of respectively constant cross-sectional profiling.

## Revendications

1. Evaporateur en ligne pour des installations de revêtement sous vide, en particulier pour des installations de revêtement de bandes, comprenant plusieurs nacelles d'évaporation (5, 5', ...) agencées dans la chambre de traitement (11) et capables d'être commandées individuellement en puissance, lesdites nacelles étant chauffées par traversée d'un courant et étant appliquées contre des éléments d'alimentation électrique (3, 3', ..., 4, 4', ...) réalisés sous la forme de mâchoires, les éléments d'alimentation (3, 4) étant maintenus ou guidés par un corps de support (6, 25) électriquement conducteur qui s'étend sur la totalité de la longueur de l'évaporateur en ligue, les éléments d'alimentation en forme de mâchoires (3, 3', ...) qui présentent une polarité étant reliés électriquement et solidairement au corps de support (6), tandis que les éléments d'alimentation en forme de mâchoires (4) qui présentent l'autre polarité sont montés de façon isolée sur le corps de support (6, 25) et sont reliés à des lignes d'alimentation (7) en courant électrique agencées de façon isolée, **caractérisé en ce que** chaque élément en forme d'alimentation en forme de mâchoires (4, 4', ...) de l'autre polarité est relié en coopération de forces, ou est réalisé d'une seule pièce avec un corps de refoulement (9, 9', ...) qui s'étend dans un plan parallèle au plan des nacelles d'évaporation (5, 5', ...), l'extrémité du corps de refoulement détournée de la nacelle d'évaporation traversant de manière étanche et en coulissement longitudinal la paroi (10) de la chambre de traitement (11), et étant exposée à la pression de l'air environnant, chaque corps de refoulement présentant un perçage borgne (13) qui s'étend dans sa direction longitudinale, ledit perçage correspondant respectivement à une amenée d'eau de refroidissement (14) et à un retour d'eau de refroidissement (15), qui débouchent tous deux depuis la face extérieure de la chambre de traitement dans l'extrémité libre du corps de refoulement exposée à l'air environnant.

2. Evaporateur en ligne selon la revendication 1, **caractérisé par** un élément de ressort (8), qui s'appuie d'une part sur le corps de support (6) ou sur la face intérieure de la paroi (10) de la chambre de traitement (11) et d'autre part sur une collerette (12) ou une saillie du corps de refoulement (9), pour produire une force de précontrainte qui agit sur la mâchoire (4) reliée au corps de refoulement (9).

3. Evaporateur en ligne selon l'une ou plusieurs des revendications précédentes, **caractérisé en ce que** l'extrémité du corps de refoulement (9), essentiellement sous forme de tige, qui dépasse vers l'extérieur jusque dans l'air environnant, est entourée par une pince (16) qui est raccordée à l'alimentation en courant (7).

4. Evaporateur en ligne selon l'une ou plusieurs des revendications précédentes, **caractérisé en ce que** le corps de refoulement (9) présente dans la région de la traversée coulissante (18) dans la paroi (10) de la chambre de traitement (11) et dans la région de la douille coulissante (17) du corps de support (6) des tronçons qui ont chacun un profil constant en section transversale.
